# EUROPEAN PATENT APPLICATION

(11) **EP 4 687 397 A1**
(43) Date of publication of application: **04.02.2026**
(21) Application number: 25188988.7
(22) Date of filing: 11.07.2025
(51) Int. Cl.: H10D 84/05, H10D 30/47, H10D 62/85, H10D 84/80, H03K 17/16, H03K 17/687

(54) **GALLIUM NITRIDE BASED INTEGRATED BIDIRECTIONAL SWITCH POWER DEVICE**

(30) Priority: 30.07.2024 IT 202400017689
(71) Applicant: STMicroelectronics International N.V., 1228 Plan-les-Ouates, Geneva (CH)
(72) Inventor: CIONI, Marcello, 41100 CAMPOGALLIANO (MO) (IT); CASTAGNA, Maria Eloisa, 95123 CATANIA (IT); IUCOLANO, Ferdinando, 95030 GRAVINA DI CATANIA (CT) (IT); SMERZI, Santo Alessandro, 95127 CATANIA (IT); PIZZARDI, Antonio Filippo Massimo, 95045 MISTERBIANCO (CT) (IT); CONTARINO, Alessandro, 95027 SAN GREGORIO DI CATANIA (CT) (IT)
(74) Representative: Studio Torta S.p.A.

(57) **Abstract**

Integrated bidirectional switch power device (30) based on gallium nitride, formed in a die (40) having a semiconductor body (41) integrating a first and a second field effect transistor (31, 32). The semiconductor body has a semiconductor substrate (42) and a layer stack (43-45) based on gallium nitride. The layer stack (43-45) is superimposed on the substrate (42) and forms a channel region and a first and a second gate region (47, 48) arranged side by side and at a mutual distance above the channel region. The substrate (42) is electrically coupled to a substrate node (SUB, 61). A first and a second conduction contact region (55, S1, 56, S2) are arranged side by side and at a mutual distance on opposite sides of the channel region and a substrate bias RC network (35) is configured to electrically couple the substrate node (SUB, 61) selectively to the first and the second conduction contact regions (55, S1, 56, S2) which is at a minimum potential.

## Description

### Technical Field

The present invention relates to a gallium nitride based, integrated, bidirectional switch power device.

### Background

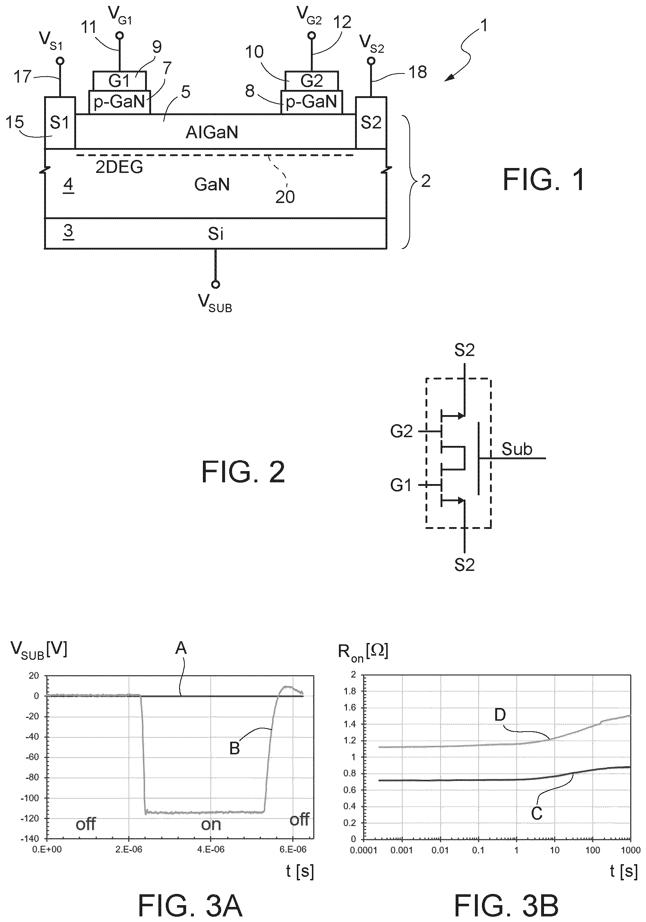

A gallium nitride based bidirectional switch power device may be formed as shown in Figure 1 and schematically represented as shown in Figure 2.

In detail, Figure 1 shows a bidirectional switch device 1 comprising a semiconductor body 2, here formed by a substrate 3, a first semiconductor layer 4 and a second semiconductor layer 5, mutually superimposed.

The substrate 3 may be, for example, of monocrystalline silicon; the first semiconductor layer 4, directly superimposed and in contact with the substrate 3, may be of a first semiconductor alloy of elements of groups III and V of the periodic table, for example of gallium nitride (GaN); and the second semiconductor layer 5, directly superimposed and in contact with the first semiconductor layer 4, may be of a second semiconductor alloy, different from the first semiconductor alloy, of elements of groups III and V of the periodic table, for example of aluminum gallium nitride (AlGaN) .

The first semiconductor layer 4 forms, in its upper part, a channel layer, and the second semiconductor layer 5 forms a barrier layer.

The first semiconductor layer 4 and the second semiconductor layer 5 are for example of N-type.

A first gate region 7 and a second gate region 8, of conductive material, extend above the second semiconductor layer 5, at a mutual distance. The first and the second gate regions 7, 8 are for example of a third semiconductor alloy, different from the first and the second semiconductor alloys, of elements of groups III and V of the periodic table, for example of P-type gallium nitride (p-GaN).

Gate electrodes 9, 10 (also indicated in Figure 1 as G1, G2), of metal, are arranged above and in direct electrical contact with the first gate region 7 and the second gate region 8, respectively, and are coupled to a first and, respectively, a second gate terminal 11, 12 configured to provide respective gate voltages Vg1, Vg2.

The bidirectional switch device 1 further comprises a first and a second source electrode 15, 16 (also indicated in Figure 1 by S1, S2) on and in contact with the first semiconductor layer 4, and are coupled to a first and, respectively, a second source terminal 17, 18.

In the bidirectional switch device 1, the first and the second semiconductor layers 4, 5 form a semiconductive heterostructure that allows a so-called 2-dimensional electron gas (2deg) to be generated, in an electronically controllable manner. A channel region (schematically indicated by 20) is thus formed, in the first semiconductor layer 4, between the first and the second source electrodes 15, 16, which allows a current to flow between the first and second source terminals 17, 18.

In particular, the bidirectional switch device 1 may be controlled in different operating modes, depending on the voltages applied to the gate terminals 11, 12 (ON voltage and OFF voltage), according to the following table 1:

**TABLE 1**

| Vg1 | Vg2 | Mode |
|---|---|---|
| OFF | OFF | Switch OFF |
| ON | ON | Switch ON |
| ON | OFF | Diode |
| OFF | ON | Diode |

For example, the OFF voltage may be equal to 0 V and the ON voltage may be equal to 6 V.

Furthermore, depending on the voltages applied to the source terminals 17, 18, currents may flow from the first source electrode 15 towards the second source electrode 16 or in the opposite direction. Consequently, in case of switching operation, each time, one of the two source terminals 17, 18 operates as a drain terminal (at a higher voltage) and the other of the two source terminals 17, 18 operates as a source terminal (at a lower voltage).

Furthermore, the bidirectional switch device 1 may operate as a diode. In this case, a same voltage is applied to one of the gate terminals 11, 12 and to the adjacent source terminal 17, 18. Consequently, each time, one of the two source terminals 17, 18 operates as an anode terminal and the other of the two source terminals 17, 18 operates as a cathode terminal.

In the bidirectional switch device 1, the voltage of the substrate 3 (indicated by V_{SUB} in Figure 1) is critical as it may negatively influence the operation of the bidirectional switch device 1, in particular during switching operation.

In particular, V_{SUB} which, in unilateral devices, is clamped to the minimum voltage in the device (typically the source voltage) here cannot be clamped to the voltage present on one of the source terminals, since, as mentioned, each source terminal S1, S2 may work (even in an alternate manner) at a higher voltage than the other source terminal S1, S2.

On the other hand, the substrate 3 cannot be left floating, because in this case a "back gating" or " back-bias" phenomenon may occur where the substrate 3 is at an intermediate voltage between the source voltages Vs1, Vs2 and behaves as an additional gate region, causing an imbalance between the voltages present on the device, a depletion of the 2-dimensional electron gas and the reduction of the conduction of the bidirectional switch device 1.

These situations are shown in Figure 3A, relating to the substrate voltage V_{SUB} in case of substrate 3 coupled to ground (i.e. to the potential of the terminal at the lower potential, here to the source terminal 17, line A) and of substrate 3 left floating (line B), in switching operation condition with voltage on the source terminals 17, 18 switching between 0 V and 200 V.

Figure 3B shows the corresponding trend of the on-resistance Ron, as a function of the stress time tₛ where line C refers to the case of substrate 3 coupled to ground and line D refers to the case of substrate 3 left floating.

To solve this problem, external circuits may be used that couple the substrate 3 to the voltage which is each time lower in the device. However, even these solutions do not satisfactorily solve the problem, both because of their complexity and as they are not able to ensure the desired speed and synchronization.

US 2022/416784A1, US 2023/282638A1 and US2014374766A1 disclose different bidirectional switch power devices for performing substrate voltage management.

The aim of the present invention is to provide a solution that overcomes the drawbacks of the prior art.

### Summary

According to the present invention, a gallium nitride based, integrated, bidirectional switch power device is provided, as defined in the attached claims.

### Brief Description of the Drawings

For a better understanding of the present invention, an embodiment thereof is now described, purely by way of nonlimiting example, with reference to the attached drawings, where:
- Figure 1 is a schematic cross-section of a known gallium nitride based bidirectional switch;
- Figure 2 is an electrical equivalent of the bidirectional switch of Figure 1;
- Figures 3A and 3B show the plots of electrical quantities of the bidirectional switch of Figure 1;
- Figure 4 shows a simplified electrical diagram of the present bidirectional power switch;
- Figure 5 shows the plots of electrical quantities of the bidirectional power switch of Figure 4;
- Figure 6 is a schematic cross-section of a possible implementation of the bidirectional power switch of Figure 4;
- Figure 7 shows the layout of a semiconductor die integrating the bidirectional power switch of Figure 4;
- Figures 8A, 8B and 8C show the simplified layouts of metal layers in the semiconductor die of Figure 7;
- Figure 9 is a cross-section, on an enlarged scale, of a possible implementation of a resistor using a gallium nitride based technology;
- Figure 10 is a cross-section of a part of the bidirectional switch of Figure 4, taken along line X-X of Figure 8A and including resistors formed as shown in Figure 9;
- Figure 11 shows a detail of the structure of Figure 10, in an enlarged scale;
- Figure 12 is a cross-section of a part of the bidirectional power switch of Figure 4, taken along line XII-XII of Figure 8A and integrating a capacitor of the bidirectional power switch of Figure 4;
- Figure 13 is a cross-section of another part of the bidirectional power switch of Figure 4, taken along line XIII-XIII of Figure 8A and integrating another capacitor of the bidirectional power switch of Figure 4;
- Figure 14 is a perspective view of a possible coupling of the die of Figure 7 to a leadframe and of its package; and
- Figure 15 is a plan view of the die of Figure 7 coupled to the leadframe of Figure 14.

### Description of Embodiments

The following description refers to the arrangement shown; consequently, expressions such as "above", "below", "upper", "lower", "right", "left" relate to the attached Figures and are not to be interpreted in a limiting manner.

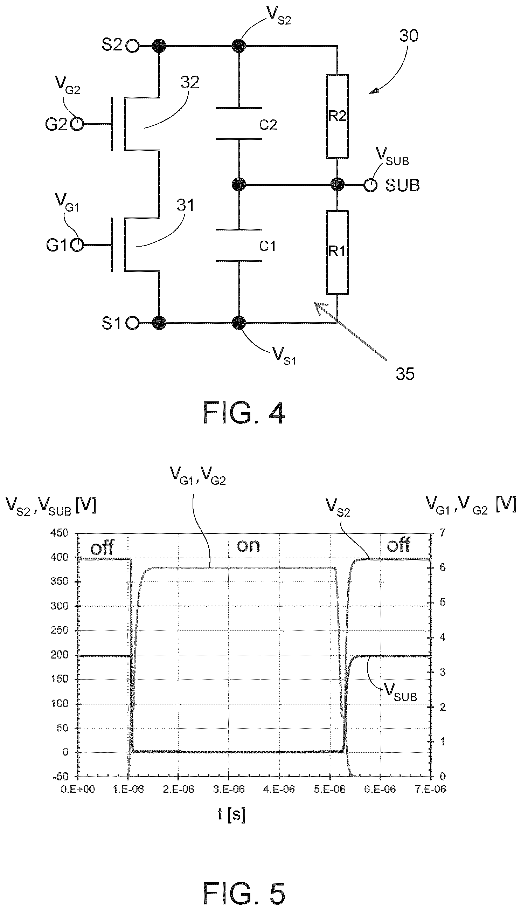

Figure 4 shows the electrical diagram of a bidirectional switch power device 30, based on gallium nitride, integrating a self-biasing network of the substrate, such as to maintain the substrate clamped to the device voltage which is each time the lowest during operation, in particular in case of switching operation.

The bidirectional switch power device 30 is schematically represented as the series-connection of a first and a second field effect transistor (FET) 31, 32, coupled between a first conduction terminal S1 and a second conduction terminal S2.

The bidirectional switch power device 30 has a first gate terminal G1 and a second gate terminal G2.

The conduction terminals S1, S2 and the gate terminals G1, G2 are intended to be connected to the outside of the bidirectional switch power device 30 through suitable leads, as described in detail below.

The first and the second conduction terminals S1, S2 are also coupled to a substrate node SUB through an RC network 35. The substrate node SUB is generally not accessible from the outside, but, if useful, may be connected externally.

The RC network 35 comprises purposedly designed resistors and capacitors and, specifically, a first capacitor C1, coupled between the first conduction terminal S1 and the substrate node SUB; a second capacitor C2, coupled between the second conduction terminal S2 and the substrate node SUB; a first resistor R1, coupled between the first conduction terminal S1 and the substrate node SUB; and a second resistor R2, coupled between the second conduction terminal S2 and the substrate node SUB.

The bidirectional switch power device 30 operates as follows (see also Figure 5), assuming that the first and the second gate terminals G1, G2 are controlled together, switching them between an ON voltage and an OFF voltage. Alternatively, the second gate terminal G2 may be coupled to the second conduction terminal S2. In this second case the second FET 32 is diode-connected.

In a first operating condition, where a negative terminal of an external power supply (not shown) is connected to the first conduction terminal S1 and a positive terminal of the external power supply is connected to the second conduction terminal S2, the first conduction terminal S1 is set at a reference voltage (first conduction voltage V_{S1}, e.g. ground); the first and the second gate terminals G1, G2 (or only second gate terminal G2) alternately receive the ON and OFF voltages (Figure 5), so as to switch on or off the bidirectional switch power device 30 (respectively, in an "ON" phase and in an "OFF" phase); the second conduction terminal S2 receives a conduction voltage V_{S2} that is high during the ON phase and low during the OFF phase (Figure 5).

For example, in the switching operation shown in Figure 5, the first and the second gate terminals G1, G2 are grounded, in the OFF phase, and to a high voltage, for example greater than 6 V, in the ON phase; and the second conduction terminal S2 is brought to a high voltage (for example 400 V), during the OFF phase and is grounded during the ON phase.

In the OFF phase, the gate terminals G1, G2 block the flow of current through the bidirectional switch power device 30; in the ON phase, the bidirectional switch power device 30 switches on and the FETs enter a linear zone, causing a current to flow from the second conduction terminal S2 toward the first conduction terminal S1.

In a second operating condition, the biases of the source terminals S1, S2 (and possibly of the gate terminals G1, G2, in case of diode-connection) are inverted with respect to the first operating condition, so that, in the on phase, a current may flow from the first conduction terminal S1 toward the second conduction terminal S2.

In the first operating condition, in the ON phase, the RC network 35 operates so as to clamp the substrate voltage V_{SUB} to the voltage of the first conduction terminal S1 (first conduction voltage V_{S1}, to ground). Furthermore, in the OFF phase, the RC network 35 maintains the substrate voltage V_{SUB} at an intermediate value between the first conduction voltage V_{S1} and the second conduction voltage V_{S2} (here, at V_{S2}/2).

In the second operating condition, the RC network 35 clamps the substrate voltage V_{SUB} to the voltage of the second conduction terminal S2 (second conduction voltage V_{S2}, to ground). In the OFF phase, the substrate voltage V_{SUB} is maintained at an intermediate value.

In practice, the RC network 35 forms a sub-bias control block which, in the ON phase, clamps the substrate voltage V_{SUB} to the conduction terminal S1, S2 at a voltage which is each time the lowest.

In other words, in both operating conditions, in the ON phase, the voltage difference between the first and the second conduction terminals S1, S2 tends to zero and approaches the lowest potential between them, avoiding the back-bias effect in the time period when the bidirectional switch power device 30 is conductive. This limits the impact of the substrate on the dynamic Ron and reduces the conduction losses with respect to a floating substrate.

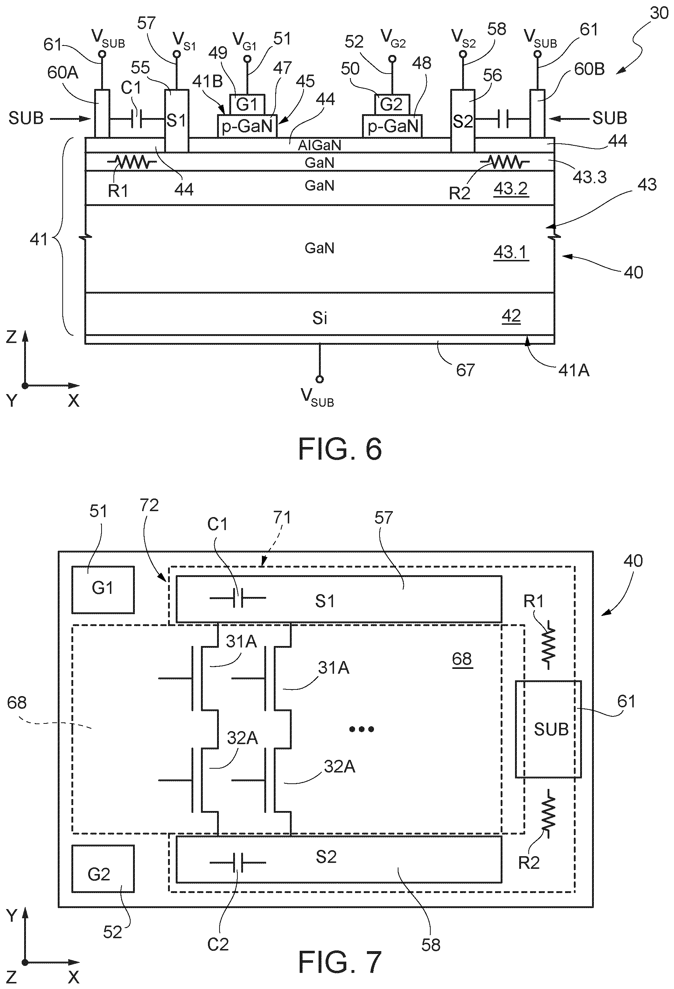

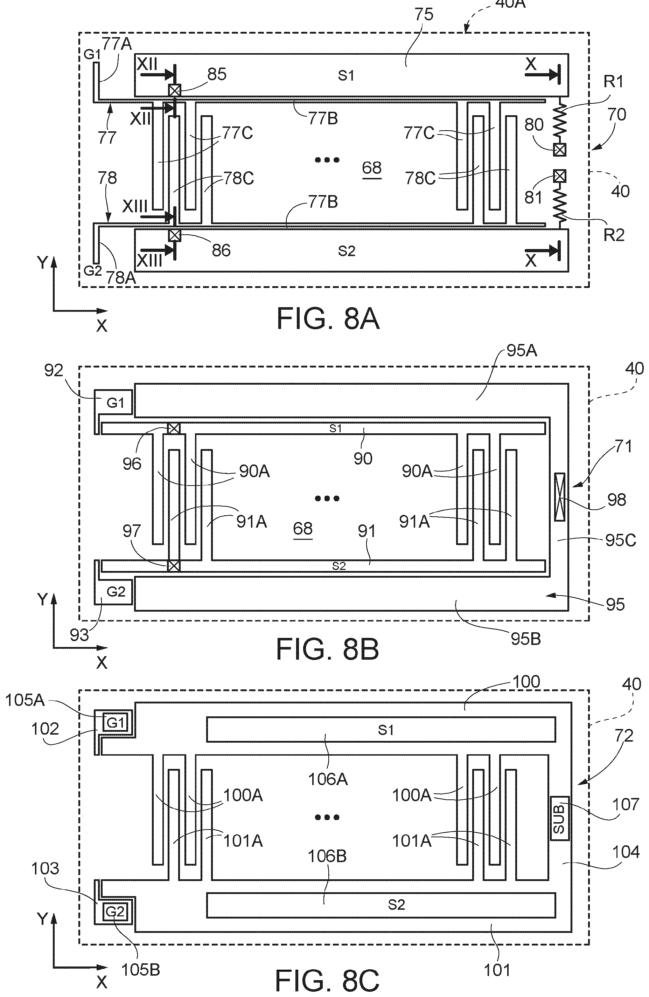

The bidirectional switch power device 30 may be implemented as shown schematically in the section of Figure 6 and in the layout of Figure 7 and shown in more detail in Figures 8A-13.

With reference to Figure 6, the bidirectional switch power device 30 is formed in a die 40 whose section is taken in an XZ plane of a Cartesian coordinate system XYZ having a first horizontal axis X, a second horizontal axis Y and a vertical axis Z.

In detail, the bidirectional switch power device 30 comprises a semiconductor body 41, here including a substrate 42, a first semiconductor layer 43, a second semiconductor layer 44 and a third conductive layer 45, mutually superimposed in the direction of the vertical axis Z.

The semiconductor body 41 has a lower surface 41A and an upper surface 41B.

The substrate 42 may be for example of monocrystalline silicon.

The first semiconductor layer 43, directly superimposed and in contact with the substrate 42, may be composed of a series of substrates formed by different alloys of elements of groups III and V of the periodic table, including gallium nitride (GaN).

In particular, in Figure 6, the first semiconductor layer 43 comprises a first sub-layer 43.1 formed by different combinations of AlGaN/GaN/AlN alloys; a second sub-layer 43.2, of GaN, forming a buffer layer; and a third sub-layer 43.3, of GaN, forming a channel layer.

The second semiconductor layer 44, directly superimposed and in contact with the first semiconductor layer 43, may be of a different semiconductor alloy of elements of groups III and V of the periodic table, for example of aluminum gallium nitride (AlGaN) and forms a barrier layer.

The first semiconductor layer 43 and the second semiconductor layer 44 are for example N-type.

The third semiconductor layer 45 is of a further semiconductor alloy of elements of groups III and V of the periodic table, which alloy is different from the alloys of the first and the second semiconductor layers 43, 44, for example of P-type gallium nitride (p-GaN). The third semiconductor layer 45 forms a first and a second gate conductive region 47, 48, which extend, at a mutual distance, above the second semiconductor layer 44.

A first and a second gate electrode 49, 50 (also indicated in Figure 6 as G1, G2), of metal, are arranged above and in direct electrical contact with the first gate conductive region 47 and the second gate conductive region 48, respectively.

The gate electrodes 49, 50 are coupled to a first and, respectively, a second gate terminal 51, 52, forming in practice the first and the second gate terminals G1, G2 of Figure 4, configured to be biased to respective gate voltages V_{G1}, V_{G2}.

The bidirectional switch power device 30 further comprises a first and a second source electrode 55, 56 (also indicated in Figure 6 by S1, S2) arranged above and in contact with the first semiconductor layer 43 (and more precisely with the third sub-layer 43.3, a channel sub-layer). The first and the second source electrodes 55, 56 are coupled to a first and, respectively, a second source terminal 57, 58, and form, in practice, the first and the second source terminals S1, S2 of Figure 4.

A first and a second substrate metal region 60A, 60B extend above the semiconductor body 41. The substrate metal regions 60A, 60B are coupled to a substrate terminal 61 set at the substrate voltage V_{SUB} and forming, in practice, the substrate node SUB of Figure 4.

Figure 6 also schematically shows the electrical arrangement of resistors R1, R2 and capacitors C1, C2.

In particular, the first resistor R1 and the first capacitor C1 extend between the first source electrode 55 and the first substrate metal region 60A; the second resistor R2 and the second capacitor C2 extend between the second source electrode 56 and the second substrate metal region 60B.

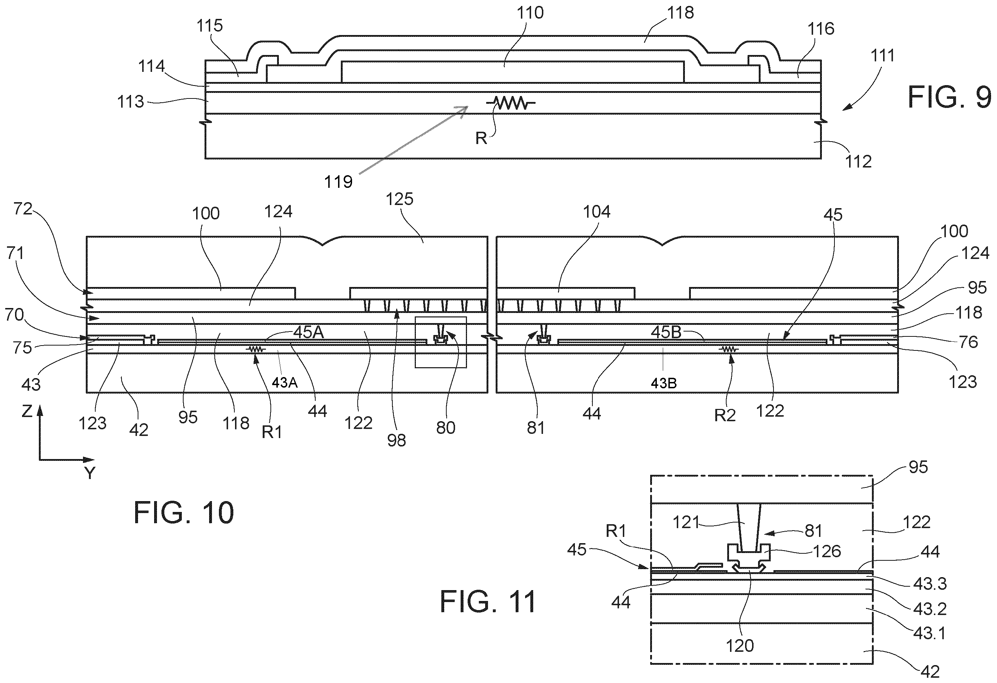

It is worth noting that, in Figure 6, the resistors R1, R2 are represented as formed in the semiconductor body 41, in the first sub-layer 43.1 of the first semiconductor layer 43. For example, Figures 9-11 show an implementation of the resistors R1, R2 integrated within the semiconductor body 41, as described in detail below. However, other implementations are possible.

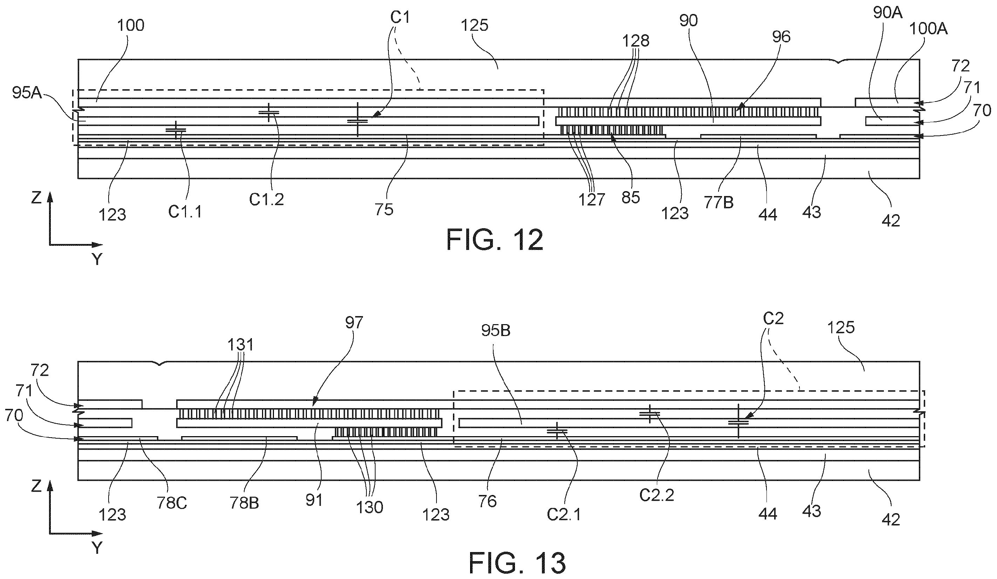

Conversely, the capacitors C1, C2 are typically formed above the semiconductor body 41, between different metallization levels of the bidirectional switch power device 30, as described in detail below with reference to Figures 12, 13.

In particular, by forming the capacitors C1, C2 as facing plates of different metallization levels, their capacitance may be selected and finely tuned in the design phase, by dimensioning their facing areas.

In fact, in general, the capacitors C1, C2 have a capacitance of the order of picofarads, which may be easily obtained with the implementation described hereinafter.

A rear metallization layer 67, at voltage V_{SUB}, extends on the lower surface 41B.

In a known and not shown manner, in the bidirectional switch power device 30, the third sub-layer 43.3, a channel sub-layer, and the second semiconductor layer 44 form a semiconductive heterostructure, which generate, in an electronically controllable manner, a 2-dimensional electron gas, 2deg.

Figure 7 shows schematically the layout of the bidirectional switch power device 30 of Figure 6. In particular, Figure 7 shows external pads forming the first and the second conduction terminals 57, 58 of Figure 6 (also indicated by S1, S2), the first and the second gate terminals 51, 52 of Figure 6, also indicated by G1, G2; and the substrate pad forming the substrate terminal 61 of Figure 6, also indicated by SUB.

Note that, in Figure 7, only one substrate terminal 61 is shown, but more than one may be present.

The bidirectional switch power device 30 comprises three metallization levels, described in detail with reference to Figures 8A-8C and including a first metallization level 70 (not visible in Figure 7 and shown in detail in Figure 8A), a second metallization level 71 (shown in dashed lines in Figure 7 and in detail in Figure 8B) and a third metallization level 72 (shown in solid lines in Figure 7 and in detail in Figure 8C).

Figure 7 shows the schematic layout of the third metallization level 72 that forms the pads S1, S2, G1, G2 and SUB and, dashed, the schematic layout of the second metallization level 71, forming part of the first and the second gate electrodes 49, 50, the first and the second source electrodes 55, 56 and the first and second gate electrodes 49, 50.

Furthermore, in this embodiment, the second metallization level 71 is used to implement the capacitors C1, C2 (represented here in a schematic manner), as described in detail below with reference to Figures 12 and 13.

Figure 7 also schematically shows the approximate position of the resistors R1, R2, formed within the semiconductor body 41, as indicated above and described in detail below with reference to Figures 9-11.

Figure 7 further schematically shows a region 68 of the semiconductor body 41 where FETs 31, 32 are formed. In the embodiment considered, the FETs 31, 32 are formed by a plurality of power elements 31A, 32A, arranged adjacent to each other and coupled in parallel.

Figures 8A-8C, 9-13 show a possible implementation of the bidirectional switch power device 30.

In detail, Figures 8A-8C show the simplified layout of the metallization levels 70-72.

In particular, in the embodiment shown in Figure 8A, the first metallization level 70 forms:
a first source lower portion 75 (forming part of the first source electrode 55 and therefore indicated by S1);
a second source lower portion 76 (forming part of the second source electrode 56 and therefore indicated by S2), a first gate lower portion 77 (forming part of the first gate electrode 49 and therefore indicated by G1); and
a second gate lower portion 78 (forming part of the second gate electrode 50 and therefore indicated by G2).

The first and the second source lower portions 75, 76 have an elongated shape and extend in proximity to respective main lateral surfaces 40A, 40B, opposite to each other, of the die 40, shown in dashed lines.

The first and the second gate lower portions 77, 78 comprise a respective gate lower intermetal connection portion 77A, 78A, a respective longitudinal portion 77B, 78B and a respective plurality of gate fingers 77C, 78C.

The gate lower intermetal connection portions 77A, 78A are arranged here in proximity to two corners of the die 40, in proximity to a respective main lateral surface 40A, 40B of the die 40.

The longitudinal portions 77B, 78B extend from a respective gate lower intermetal connection portion 77A, 78A, laterally to a respective source lower portion 75, 76, in a longitudinal direction, parallel to the first horizontal axis X.

Here, the longitudinal portions 77B, 78B are arranged between the source lower portions 75, 76.

The gate fingers 77C, 78C extend, in a direction parallel to the second horizontal axis Y, from a respective longitudinal portion 77B, 78B towards the opposite longitudinal portion 78B, 77B and are comb-like arranged (interdigitated) above the region 68 of the semiconductor body 41, indicated here for clarity.

In this manner, each gate finger 77C of the first gate lower portion 77 forms, with an adjacent gate finger 78C of the second gate lower portion 78, with the source lower portions 75, 76 and with the region 68 of the semiconductor body 41, a power element 31A, 32A (Figure 7), placed in parallel to the other adjacent power elements 31A, 32A.

Furthermore, here, the first metallization level 70 forms part of a first and a second substrate contact structure 80, 81.

Each substrate contact structure 80, 81 includes an ohmic contact for forming the first resistor R1, respectively the second resistor R2 (represented here by the electrical equivalents) and vias for their connection to the second metallization level 71, as shown in Figures 9-11 and described in detail below.

Furthermore, Figure 8A schematically shows a first and a second source intermetal connection 85, 86, for source coupling between the first and the second metallization levels 70, 71, as described in more detail below.

Figure 8B shows a layout example of the second metallization level 71.

In detail, in Figure 8B, the second metallization level 71 forms:
a first source intermediate portion 90 coupled to the first source lower portion 75 at the first source intermetal connection 85 (Figures 8A and 12), also indicated by S1;
a second source intermediate portion 91, coupled to the second source lower portion 76 at the second source intermetal connection 86 (Figures 8A and 13), also indicated by S2;
a first gate intermediate connection 92 (coupled to the first gate lower portion 77 and therefore indicated by G1);
a second gate intermediate connection 93 (coupled to the second gate lower portion 78 and therefore indicated by G2); and
a substrate intermediate region 95 coupled to the first and the second substrate contact structures 80, 81 as shown in Figures 10 and 11.

The substrate intermediate region 95 is U-shaped, including a first arm 95A overlying the first source lower portion 75; a second arm 95B overlying the second source lower portion 76; and a connection arm 95C, extending between the first and the second arms 95A, 95B, above the zone of the resistors R1, R2 of Figure 8A.

The second metallization level 71 here also forms intermediate source fingers 90A, 91A, extending from the first source intermediate portion 90, respectively from the second source intermediate portion 91 toward the opposite source intermediate portion 91, 90 and interdigitated. For example, the intermediate source fingers 90A, 91A (having a function of distributing the voltage and ensuring a better current distribution) extend parallel to the second horizontal axis Y.

Furthermore, a third and a fourth source intermetal connection 96, 97 as well as a substrate intermetal connection 98 are schematically represented in Figure 8B, for coupling the second and the third metallization level 71, 72, as described in more detail below.

Figure 8C shows a layout example of the third metallization level 72.

In detail, in Figure 8C, the third metallization level 72 forms:
a first source upper portion 100, coupled to the first source intermediate portion 90 at the third source intermetal connection 96 (Figures 8B and 12), also indicated by S1;
a second source upper portion 101, coupled to the second source intermediate portion 91 at the fourth source intermetal connection 97 (Figures 8B and 13), also indicated by S2;
a first gate upper connection 102, coupled to the first gate intermediate connection 92 and therefore indicated by G1;
a second gate upper connection 103, coupled to the second gate intermediate connection 93 and therefore indicated by G2; and
a substrate upper connection 104, coupled to the substrate intermediate region 95, as shown in Figures 10 and 11 and described in detail below.

The third metallization level 72 here also forms upper source fingers 100A, 101A, extending from the first source upper portion 100, respectively the second source upper portion 101 and interdigitated.

Figure 8C also shows gate pads 105A, 105B, formed directly by the third metallization level 72 and in direct electrical contact with the first and respectively the second gate upper connection 102, 103; source pads 106A, 106B, formed directly by the third metallization level 72 and in direct electrical contact with the first and respectively the second source upper portion 100, 101; and a substrate pad 107 in direct electrical contact with the substrate upper connection 104.

Figure 9 shows a possible embodiment of resistors R1, R2 that exploits the presence of the third semiconductor layer 45, of p-GaN, which forms the first and the second gate conductive regions 47, 48 of Figure 6. In fact, the third semiconductor layer 45 allows to partially deplete the 2-dimensional electron gas, 2deg, forming in the underlying layer, and therefore to increase the resistivity of this zone.

In Figure 9, a depleting region 110, of p-GaN, is superimposed on a body 111 comprising a substrate 112, for example of silicon possibly covered by one or more layers of GaN, a channel layer 113, for example of a GaN alloy, and a barrier layer 114, of AlGaN.

For example, the substrate 112 may comprise the substrate 42, the second and the third sub-layers 43.1 and 43.2 of Figure 6; the channel layer 113 may comprise the third sub-layer 43.3, of Figure 6; and the barrier layer 114 may comprise the second semiconductor layer 44 of Figure 6.

As indicated, the depleting region 110 is superimposed on the barrier layer 114 and is arranged between a first and a second ohmic contacts 115, 116. For example, the first ohmic contact 115 may be formed by one of the substrate contact regions 80, 81 of Figure 8A and the second ohmic contact 116 may be formed by the first or the second source lower portion 75, 76 of Figure 8A, as described in detail below.

An insulating layer 118 covers here the depleting region 110.

The presence of the depleting region 110 causes an increase in the resistance of the portion of the channel layer 113 between the two ohmic contacts 115, 116, forming a resistor R in the channel layer 113 (resistive portion 119). In this manner, resistors having a reduced length, integrated directly in the die 40 may be obtained.

Figure 10 shows an implementation of the resistors R1, R2 in the die 40 using the solution of Figure 9. Figure 10 also shows the substrate contact structures 80, 81 and the substrate intermetal connection 98 between the semiconductor body 41 and the metallization levels 70-72.

In detail, Figure 10 shows, on the left, the first resistor R1 and, on the right, the second resistor R2.

The resistors R1, R2 are formed as shown in Figure 9. In particular, here the resistors R1, R2 are formed by resistive portions 43A, 43B of the channel layer 43.3.

In particular, the resistive portions 43A, 43B extend between a respective first and second source lower portion 75 (on the left edge of Figure 10) and 76 (on the right edge of Figure 10) and a respective substrate contact structure 80 (in the left half, toward the center) and 81 (in the right half, toward the center).

Each substrate contact structure 80, 81 (see in particular Figure 11 showing the detail of the first substrate contact structure 80 in the square of Figure 10) is formed here by an ohmic contact region 120, for example formed by a multilayer of Ti/AlCu/TiN, here in direct physical contact with the first semiconductor layer 43 of the semiconductor body 41 (and more precisely with the third sub-layer 43.3, a channel sub-layer), by an overlying metallization portion 126, formed by the first metallization level 70, and by a substrate via 121, of metal, extending within a first dielectric layer 122 arranged between the first and the second metallization levels 70, 71.

The substrate metal via 121 extends here from the metallization portion 126 up to the second metallization level 71, extending, together with the ohmic contact 120 and the metallization portion 126, across the first dielectric layer 122 and electrically coupling the respective end of the resistor R1, R2 to the semiconductor body 41 and to the substrate intermediate region 95, at the metallization portion 126 (Figure 8B).

Figure 10 also shows a thin surface insulating layer 123, extending between the semiconductor body 41 and the source lower portions 75, 76; a second dielectric layer 124, extending between the second and the third metallization levels 71, 72; the substrate intermetal connection 98, formed by a plurality of metal vias extending across the second dielectric layer 124 and electrically coupling the substrate intermediate region 95 in the second metallization level 71 (Figure 8B) to the substrate upper region 104 in the third metallization level 72 (Figure 8C); and a passivation layer 125 (for example formed by a plurality of superimposed insulating layers) extending above the third metallization level 72.

Figures 12 and 13 show a possible implementation of the capacitors C1, C2 in the die 40 using the metallization levels 70-72.

In particular, the third metallization level 72 may be used to form first plates (electrically coupled to the first and the second conduction terminals S1, S2) of upper capacitors whose second plates are formed by the second metallization level 71 forming the substrate node SUB of Figure 4.

Furthermore, the first metallization level 70 may be used to form first plates (also electrically coupled to the first and the second conduction terminals S1, S2) of lower capacitors whose second plates are again formed by the second metallization level 71.

Using vias, the first plates formed in the first and the third metallization levels 70, 72 may be electrically coupled to each other, thus doubling the capacitance with a same occupied area, as described hereinbelow.

In detail, Figure 12 shows the implementation of the first capacitor C1 as the sum of a first and a second sub-capacitor C1_1 and C1_2, where the first sub-capacitor C1_1 is formed between the first metallization level 70 (and precisely the first source lower portion 75) and the second metallization level 71 (and precisely the first arm 95A of the substrate intermediate region 95) and the second sub-capacitor C1_2 is formed between the second metallization level 71 (and precisely the first arm 95A of the substrate intermediate region 95) and the third metallization level 72 (and precisely the first source upper portion 100).

Figure 12 also shows a possible implementation of the first and the third source intermetal connections 85, 96 that electrically couple the first source lower portion 75 and the first source upper portion 100, connecting in parallel the first and the second sub-capacitors C1_1 and C1_2.

In detail, the first source lower portion 75 is wider, in a direction parallel to the second horizontal axis Y, than the first arm 95A of the substrate intermediate region 95 and extends beyond such first arm 95A toward the second arm 95B (Figure 8B) up to below the first source intermediate portion 90. Here, the first source lower portion 75 is electrically connected to the first source intermediate portion 90 through second substrate vias 127, forming the first source intermetal connection 85.

Furthermore, the first source upper portion 100 is wider, in a direction parallel to the second horizontal axis Y, than the first arm 95A of the substrate intermediate region 95 and extends beyond such first arm 95A toward the second arm 95B (Figure 8B) up to above the first source intermediate portion 90. Here, the first source upper portion 100 is electrically connected to the first source intermediate portion 90 through third substrate vias 128, forming the third source intermetal connection 96 (Figure 8B) .

In this manner, the first capacitor C1 may extend practically throughout the entire length of the main lateral surface 40A of the die 40, Figure 8A (except for the first gate upper connection 102, Figure 8C). The area of the first capacitor C1 therefore depends on the superimposition area between the first source lower portion 75 and the first arm 95A of the substrate intermediate region 95 and between the latter and the first source upper portion 100, and may have doubled capacitance.

Similarly, Figure 13, the second source lower portion 76 is wider, in a direction parallel to the second horizontal axis Y, than the second arm 95B of the substrate intermediate region 95 and extends beyond this second arm 95B toward the first arm 95A (Figure 8B) up to below the second source intermediate portion 91. Here, the second source lower portion 76 is electrically connected to the second source intermediate portion 91 through fourth substrate vias 130, forming the second source intermetal connection 86.

Furthermore, the second source upper portion 101 is wider, in a direction parallel to the second horizontal axis Y, than the second arm 95B of the substrate intermediate region 95 and extends beyond this second arm 95B toward the first arm 95A (Figure 8B) up to above the second source intermediate portion 91. Here, the second source upper portion 101 is electrically connected to the second source intermediate portion 91 through fifth substrate vias 131, forming the fourth source intermetal connection 97 (Figure 8B) .

A third and a fourth sub-capacitor C2_1 and C2_2, parallel-connected, are thus formed.

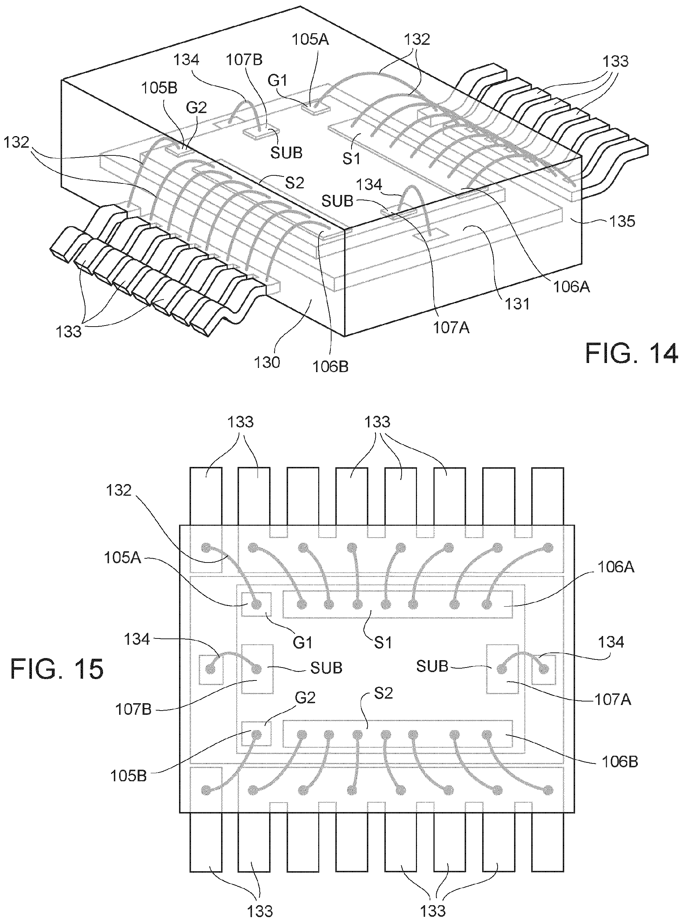

The bidirectional switch power device 30 may be packaged in a TOLT (TOp-side-Leaded cooling package) type case, as shown in Figures 14 and 15.

In detail, the die 40 is attached to a leadframe 130 bonding the rear metallization layer 67 (Figure 6) to a support portion 131 of the leadframe 130; wires 132 couple the gate and source pads 105A, 106A, 106B to respective leads 133 of the leadframe 130.

In the embodiment shown, the bidirectional switch power device 30 has two substrate pads, indicated by 107A, 107B, coupled to the support portion 131 through respective wires 134.

An insulating housing 135, for example of resin, incorporates the support portion 131, the die 40, the wires 132, 134 and the initial portion of the leads 133, in a manner known per se.

By virtue of the arrangement shown in Figures 14, 15, and with reference to Figure 6, the lower surface 41B of the semiconductor body 41 (and therefore the substrate 42) may be electrically connected to the upper surface 41A and therefore to the substrate node 60A, 60B.

In practice, in this manner, the substrate 42 is connected in a simple manner to the substrate terminal (SUB) 61 which, as discussed above, is maintained coupled, each time, to the lowest potential in the die 40.

Finally, it is clear that modifications and variations may be made to the bidirectional switch power device described and illustrated here without thereby departing from the scope of the present invention, as defined in the attached claims.

For example, the electrical connection between the substrate terminals SUB and the substrate 42 may be implemented differently, through direct coupling, or by conductive vias traversing the semiconductor body 41.

Furthermore, the resistors might be formed differently, for example by suitable local doping of the channel layer 43.3 or without providing the depleting region 110 of Figure 9, with a suitable choice of the distance between the ohmic contacts 115, 116 exploiting the non-zero resistivity of the 2-dimensional gas. Alternatively, the resistors might be formed in the upper metal levels 71, 72 using high-resistivity materials (for example SiCr and TaN).

The ohmic contacts 120 may be formed in contact with the barrier layer 114 (partially recessed solution).

## Claims

1. An integrated bidirectional switch power device (30) based on gallium nitride, comprising a die (40) including:
a semiconductor body (41) integrating a first and a second field effect transistor (31, 32), the semiconductor body comprising a semiconductor substrate (42) and a layer stack (43-45) based on gallium nitride and superimposed on the substrate (42), the layer stack (43-45) forming a channel region and a first and a second gate region (47, 48) arranged side by side and at a mutual distance above the channel region, the substrate (42) being electrically coupled to a substrate node (SUB, 61);
a first and a second conduction contact region (55, S1, 56, S2) arranged side by side and at a mutual distance on opposite sides of the channel region;
a substrate bias RC network (35) configured to electrically couple the substrate node (SUB, 61) selectively to the first and the second conduction contact regions (55, S1, 56, S2) which is at a minimum potential, the substrate bias RC network (35) comprising purposedly designed resistors and capacitors,
wherein the substrate bias RC network (35) comprises:
a first resistor (R1) coupled between the first conduction contact region (55, S1) and the substrate node (SUB, 61);
a second resistor (R2) coupled between the second conduction contact region (56) and the substrate node (SUB, 61);
a first capacitor (C1) coupled between the first conduction contact region (55) and the substrate node (SUB, 61); and
a second capacitor (C2) coupled between the second conduction contact region (56) and the substrate node (SUB, 61).

2. The device according to claim 1, wherein the channel region is formed in a channel layer (43.3) of gallium nitride and the first and the second resistors are formed in a first and second resistive portion (119; 43A, 43B) of the channel layer (43.3), the first and the second resistive portions (119; 43A, 43B) being arranged laterally to the channel region.

3. The device according to the preceding claim, wherein the first and the second resistive portions (119; 43A, 43B) are overlaid by a first and, respectively, a second depleting region (110; 44).

4. The device according to the preceding claim, wherein the first and the second resistive portions (119; 43A, 43B) are of gallium nitride of a first conductivity type, and the first and second depleting regions (110; 44) are of gallium nitride of a second conductivity type.

5. The device according to any of claims 2-4, wherein the first and the second resistive portions (119; 43A, 43B) have a first terminal ohmically coupled to the substrate (42) and to the substrate node (SUB, 61).

6. The device according to any of the preceding claims, comprising at least one first metal layer (70) and one second metal layer (71) overlying the semiconductor body (41) and mutually insulated by a first dielectric layer (122), wherein the first capacitor (C1) comprises a first capacitive element (C1_1) formed by first capacitor portions (75, 95A), mutually superimposed, of the first and the second metal layers (70, 71) and by a first portion of the dielectric layer (122), interposed between the first capacitor portions, and the second capacitor (C2) comprises a second capacitive element (C2_1) formed by second capacitor portions (76, 95B), mutually superimposed, of the first and the second metal layers (70, 71) and by a second portion of the dielectric layer (122), interposed between the second capacitor portions.

7. The device according to the preceding claim, wherein the first and the second metal layers (70, 71) comprise respective first gate contact portions (77A, 92) electrically connected to each other and coupled to the first gate region (47), respective second gate contact portions (78A, 93) electrically connected to each other and coupled to the second gate region (48), first conduction contact portions (75, 90) electrically connected to each other and forming the first conduction contact region (55, S1) and second conduction contact portions (76, 91) electrically connected to each other and forming the second conduction contact region (56, S2).

8. The device according to claim 6 or 7, wherein the first and the second metal layers (70, 71) comprise a respective first substrate bias portion (80, 81, 95B), the first substrate bias portions of the first and the second metal layers being electrically coupled to each other and forming the substrate node (SUB, 61).

9. The device according to any of claims 6-8, further comprising a third metal layer (72) superimposed on the second metal layer (71) and insulated therefrom by a second dielectric layer (124), wherein the third metal layer (70) comprises third capacitor portions (100), superimposed on the first capacitor portions (95A) of the second metal layer (72) and fourth capacitor portions (101), superimposed on the second capacitor portions (95B) of the second metal layer (72), wherein the third and the fourth capacitor portions (100, 101) form, with the first and, respectively, the second capacitor portions (95A, 95B) of the second metal layer (70), a third and a fourth capacitive element (C1_2, C2_2) coupled in parallel to the first and, respectively, the second capacitive element (C1_1, C2_1) through third and, respectively, fourth conduction contact regions (96, 97).

10. The device according to the preceding claim, wherein the second metal layer 71 is shaped as a U having a first arm 95A, a second arm 95B, and a transverse arm 95C extending between the first and the second arms, wherein the first arm 95A forms the first capacitor portions (95A) of the second metal layer (72), and the second arm forms the second capacitor portions (95B) of the second metal layer (71).

11. The device according to the preceding claim when depending on claim 8, wherein the transverse arm (95B) forms the first substrate bias portion of the second metal layer (72) and is electrically coupled to a second substrate bias portion (104) of the third metal layer (72).

12. The device according to any of the preceding claims, wherein the semiconductor body comprises a first semiconductor layer (43) including a first sub-layer (43.1) including a first GaN alloy, superimposed on the substrate (42); a buffer layer (43.2) including a second GaN alloy, superimposed on the first sub-layer (43.1); a channel layer (43.3) including a third GaN alloy, superimposed on the buffer layer (43.2) and forming the channel region (20); a barrier layer (44) including aluminum gallium nitride, superimposed on the channel layer (43.3) and forming a heterostructure therewith; wherein the gate regions (47, 48) are arranged above the barrier layer (44) and comprise a fourth GaN alloy with opposite conductivity with respect to the channel layer (43.3) and the barrier layer (44).

13. The device according to any of the preceding claims, wherein the substrate (42) of the semiconductor body (41) is bonded to a leadframe portion (131) of a leadframe (130) and a bonding wire (134) couples the substrate node (SUB, 61) to the leadframe portion of the leadframe (130).

14. The device according to the preceding claim, wherein the die (40) and the leadframe (130) are packaged in an electrically insulating housing (135) and form a TOLT - TOp-side-Leaded cooling - package.
